# EUROPEAN PATENT SPECIFICATION

(11) **EP 0 477 990 B1**
(45) Date of publication and mention of the grant of the patent: **27.12.1996**
(21) Application number: 91116701.3
(22) Date of filing: 30.09.1991
(51) Int. Cl.: C23C 14/58, C23C 14/56

(54) **A method of enhancing the properties of a thin film on a substrate**
Verfahren zum Verbessern der Eigenschaften einer Dünnschicht auf einem Substrat
Méthode pour améliorer les propriétés d'une couche mince sur un substrat

(30) Priority: 28.09.1990 US 590254; 23.08.1991 US 748215
(43) Date of publication of application: 01.04.1992
(73) Proprietor: APPLIED MATERIALS, INC., Santa Clara, California 95054-3299 (US)
(72) Inventor: Gilboa, Haim, Palo Alto, CA 94306 (US); Mosely, Roderick C., Mountain View, CA 94043 (US)
(74) Representative: Diehl, Hermann O. Th., Dr.

(56) References cited:
- EP-A- 0 272 141
- EP-A- 0 299 870
- EP-A- 0 452 891
- THIN SOLID FILMS vol. 141, no. 2, 1986, LAUSANNE CH pages 223 - 228 B. WENDLER "VACUUM ANNEALING STUDIES OF THE STRUCTURE AND OF MECHANICAL PROPERTIES OF THIN TITANIUM NITRIDE FILMS DEPOSITED BY ACTIVATED REACTIVE EVAPORATION"
- DATABASE WPIL Section Ch, Week 8933, Derwent Publications Ltd., London, GB; Class C01, AN 89-237610 & JP-A-1172222
- THIN SOLID FILMS vol. 96, 1982, LAUSANNE CH pages 327 - 345 C.Y. TING, M. WITTMER 'THE USE OF TITANIUM BASED CONTACT BARRIER LAYERS IN SILICON TECHNOLOGYY'

## Description

The present invention is directed to a method of enhancing the properties of a thin film on a substrate.

After the deposition on a substrate of certain thin films composed of, for example, titanium nitride, it has been the practice to expose the deposited thin films to air and then to anneal the deposited thin film. The annealing has been done by heating the substrate with the deposited thin film in a furnace with an atmosphere of nitrogen or forming gas.

The air exposure and/or annealing in a furnace has been performed to allow nitrogen and oxygen to react with the deposited thin film. One result of the air exposure and/or annealing is to improve the barrier properties between the deposited thin film and subsequently deposited layers. For example, when aluminum is deposited over a thin film of titanium nitride, air exposure and/or annealing of the film of titanium nitride has been shown to reduce the amount of aluminum which diffuses into the titanium nitride film. Further, the air exposure and/or annealing also reduces the amount of free titanium which diffuses into the subsequently deposited layer of aluminum. Such reduction of diffusion results in improved device reliability.

One drawback of the above-discussed prior art processes is the amount of time required to remove substrates from a vacuum deposition chamber to expose the deposited thin film to air. Further, enhancing the barrier properties by air exposure is particularly time consuming and a difficult process to control.

The document EP-A-0 452 891 discloses a process for forming a conductive layer of titanium silicide on a silicon semiconductor wafer which comprises the steps of forming a titanium layer over the wafer in oxygen bearing gases; transferring the titanium coated wafer to a sealed annealing chamber without substantially exposing the newly formed titanium layer to oxygen and/or oxygen-bearing gases; and annealing the titanium coated silicon semiconductor wafer in a nitrogen bearing atmosphere in the second annealing chamber, and in the substantial absence of oxygen and/or oxygen bearing gases.

The invention provides an improved method of enhancing the barrier properties of a thin film on a semiconductor substrate according to independent claim 1. Further advantageous features, aspects and details of the method are evident from the dependent claims, the description and drawings. The invention provides a plasma or thermal annealing process to enhance barrier properties of deposited thin films. It is directed to a plasma or thermal annealing process used in the production of devices on substrates, which achieves improved barrier properties of thin film, such as titanium nitride.

In accordance with a preferred embodiment of the present invention, a method is presented for enhancing properties of thin films deposited on a substrate. First a layer of the thin film is deposited on a substrate, as by sputtering. Then, without removing the substrate from a vacuum environment, the deposited layer of the thin film is annealed. The annealing may be a plasma anneal or a thermal anneal. The deposition and annealing may be performed in the same chamber or may be performed in different chambers, provided the substrate can be transferred between chambers while remaining in a vacuum environment.

Figure 1 is a simplified block diagram showing a sputtering apparatus used for a sputter deposition process in accordance with the preferred embodiment of the present invention.

Figure 2 shows a block diagram of a chamber in which plasma or thermal annealing may be performed in accordance with the preferred embodiment of the present invention.

Figure 3 shows a top view of a block diagram of semiconductor processing equipment which includes a plurality of interconnected vacuum processing chambers.

Figure 4 is a sputtered neutral mass spectroscopy (hereinafter SNMS) graph showing the concentration of various atoms in the film after heating titanium nitride on silicon over which aluminum has been deposited for 90 minutes at 450°C under vacuum.

Figure 5 is an SNMS graph showing the concentration of various atoms after exposing titanium nitride on silicon to air, depositing an aluminum film thereover and then annealing for 90 minutes at 450°C.

Figure 6 is an SNMS graph showing concentration of various atoms after plasma annealing titanium nitride on silicon with oxygen. After aluminum has been deposited, the sandwich was annealed for 90 minutes at 450°C.

Figure 7 is an SNMS graph showing the concentration of various atoms after plasma annealing titanium nitride on silicon with nitrous oxide. After aluminum has been deposited, the sandwich was annealed for 90 minutes at 450°C.

Figure 8 is a graph of sheet resistance of the aluminum layer of the sandwich of Figure 7 versus annealing time.

The process of the invention may be used on a variety of thin film materials. For example, the barrier properties of a deposited thin film of titanium nitride may be enhanced by plasma annealing the deposited thin film with nitrous oxide (N₂O) or oxygen (O₂). The barrier properties of a deposited thin film of titanium tungsten may be enhanced by plasma annealing the deposited thin film with nitrogen or ammonia. The barrier properties of a deposited thin film of tantalum nitride may be enhanced by plasma annealing the deposited thin film with nitrous oxide or oxygen. The thin films can be deposited by sputtering.

The techniques herein described may also be utilized to enhance other properties of deposited thin films. For example, a thin film of aluminum may be plasma annealed in fluorine or nitrogen trifluoride (NF₃) in order to prevent grain growth, hillock formation and to enhance electromigration resistance.

The present invention has many advantages over the prior art processes. For example, the present process can be performed without removing a substrate from the vacuum chamber in which the deposition is performed. Also, when a plasma anneal is performed, the deposited thin film material is bombarded with ions, neutrals and excited gas molecules. Such bombardment increases the rate of reaction between the gas molecules and the deposited thin film material. Further, the plasma anneal process is easily controllable since the bombardment energy of the gas molecules varies with the operating power and atmospheric pressure within the plasma annealing chamber. Finally, the present process may be performed without utilizing an undue amount of time.

The invention will be further described with reference to the drawings. The process is illustrated using a silicon semiconductor wafer, but other substrates can be substituted as will be known to one skilled in the art. The process is illustrated by sputter depositing the thin films.

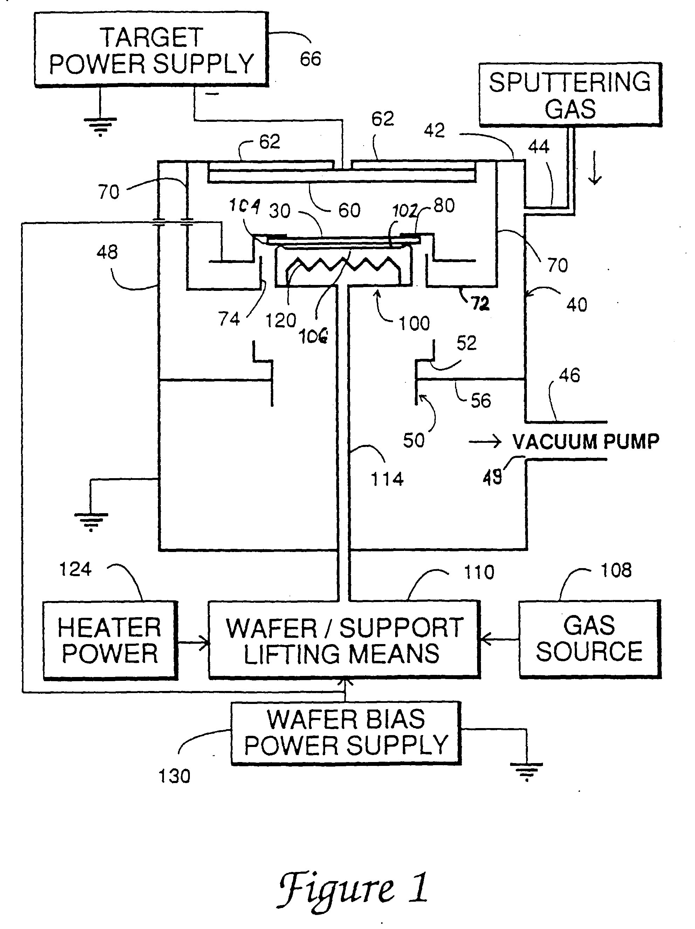

In Figure 1, a sputtering apparatus is shown. A wafer 30 is initially inserted into a sputtering chamber 40 comprising a top wall 42 and sidewalls 48. The wafer 30 is placed on a wafer support member, such as a cylindrical or ring shaped wafer support member 50. The wafer support member 50 is provided with an enlarged upper flange 52 of a diameter suitable to provide a support for the wafer 30. The wafer support member 50 may be mounted to the sidewalls 48 of the chamber 40 by pins or brackets 56.

The chamber 40 is further provided with a sputtering gas inlet port 44 connected to a source of a sputtering gas such as argon (not shown). The sputtering gas is flowed into the chamber 40 at a rate of from about 30 standard cubic centimeters per minute (sccm) to about 300 sccm. An outlet port 49 in the chamber 40 is connected to a vacuum pump via a duct 46 to maintain a pressure within the sputtering chamber 40 within a range of from about one to about eight millitorr.*
* 1millitorr = 1.3 x 10⁻⁶bar

Mounted to the top wall 42 of the chamber 40 is an aluminum target 60 which is insulated from the grounded sidewalls 48 of the chamber 40 by insulators 62. The target 60 is electrically connected to the negative terminal of a power supply 66. The power supply 66 has an adjustable (resettable) power level.

Surrounding the target 60 and mounted to the top wall 42 of the chamber 40 is a cylindrical shield member 70. The cylindrical shield member 70 is provided with a lower flange or shoulder 72 and an upwardly extending inner lip 74 which carries a clamping ring 80 to engage the edges of the top surface of the wafer 30 when the wafer 30 is raised to a sputtering position and to seal the wafer 30 to a circular wafer support platform 100.

The wafer support platform 100 is used to lift the wafer 30 from the wafer support 50 and into position within the shield 70 and beneath the target 60 to permit the sputter deposition of, for example, an aluminum layer on the wafer 30. The wafer support platform 100 also serves as a heating means, a heat stabilizing means, and a biasing means for the wafer 30.

The platform 100 is initially raised to a position where it lifts the wafer 30 from the cylindrical support 50 via lifting means 110 which may, for example, comprise a fluid power cylinder coupled to the platform 100 via a hollow shaft or rod 114.

The platform 100 also contains heating means 120 comprising an electrical resistance heater electrically connected through the hollow shaft 114 to a heater power supply 124. The heater means 120 serves to initially heat the wafer 30 when the sputter deposition process is commenced. The platform 100 may be further provided with cooling means, such as water cooling coils (not shown) to further stabilize the temperature of the platform 100.

To stabilize the temperature of the wafer 30 during a portion of the sputtering process, the platform 100 is further provided with a crown 104 adjacent to the edge of the convex top surface 102 of the platform 100. The crown 104 cooperates with the clamping ring 80 to seal the edges of the back surface of the wafer 30 to the top surface 102 of the platform 100, thereby defining therebetween a sealed chamber having a thickness of about one to about two µm between the back surface of the wafer 30 and the top surface 102 of the platform 100 into which a thermally conductive gas, such as argon, may be admitted through an opening 106 in the top surface 102 of the platform 100 during a portion of the process.

The thermally conductive gas, which is supplied from a gas source 108 through the hollow shaft 114, serves to thermally couple the wafer 30 to the platform 100. As excess heat builds up in the wafer 30 during the sputtering process, such heat is transmitted through the gas from the wafer 30 to the platform 100, which has much greater mass than the wafer and therefore acts as a large heat sink to absorb the additional heat as it is generated.

The wafer 30 may be electrically biased with respect to the grounded chamber 40 through the platform 100 and the clamping ring 80 from a biasing power supply 130. The bias may be a DC or AC bias applied to the wafer 30.

After a thin film has been deposited on a wafer, a plasma or thermal annealing of the deposited thin film is used to enhance the boundary properties at the top of the deposited thin film. For example, a titanium nitride (TiN) thin film on which an aluminum (Al) film will be deposited may be plasma or thermally annealed in order to reduce interdiffusion into the films.

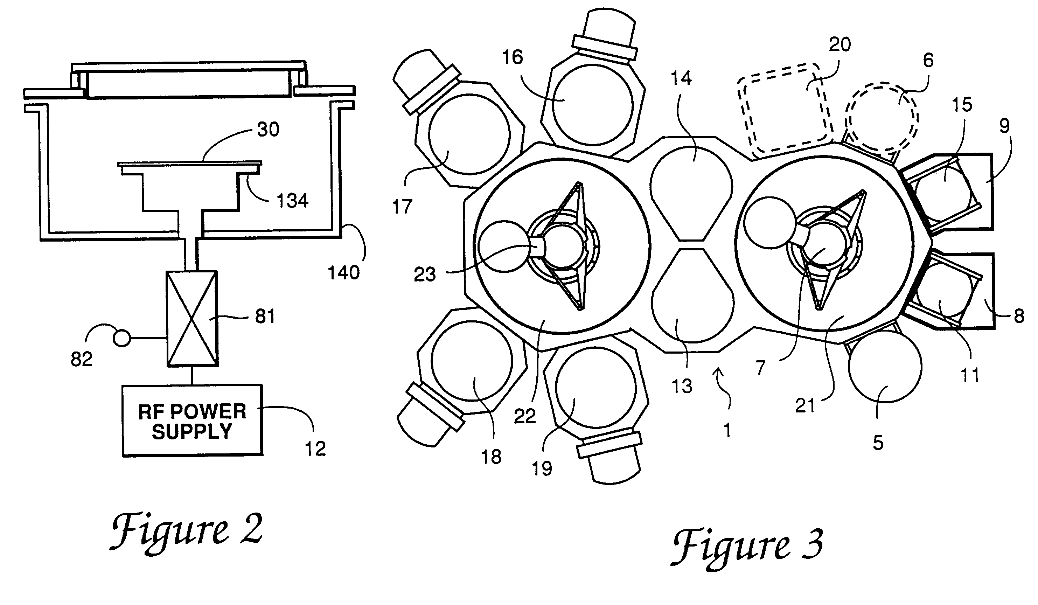

The plasma or thermal anneal may be performed in the chamber 40 or the plasma anneal may be performed in a separate chamber. Figure 2 shows a block diagram of a chamber 140 configured to perform a plasma or thermal anneal. The wafer 30 is set upon a heater 134 within the chamber 140. The heater 134 is able to heat the wafer 30 to a temperature between about 300°C and 500°C in order to perform a thermal anneal.

For a plasma anneal, a radio frequency (RF) power supply 12 supplies power. A matching network 81 matches impedances for efficient power transfer. A DC bias is provided on an input 82.

During the plasma annealing steps, the pressure inside the chamber 140 is about 0.67 Pa [5 millitorr]. A DC wafer bias circuit provides a DC bias of 200 volts on input 82. The RF wafer power supply 12 provides a 60 megahertz signal at 550 watts. The plasma is generated for about one minute. However, processing times and other parameters may be varied to obtain optimal enhancement of a particular barrier film.

The process of the invention is not limited to the enhancement of titanium nitride films; different plasma anneal gases and/or different deposited thin film materials may be utilized. For example, to enhance the barrier properties of titanium nitride (TiN) the plasma annealing process may be performed using a plasma generated from oxygen. Similarly, the barrier properties of a titanium tungsten (TiW) film can be enhanced by performing a plasma annealing process using a plasma generated from nitrogen (N₂) or ammonia (NH₃); or the barrier properties of a tantalum nitride (TaN) thin film may be enhanced by performing a plasma annealing process using a plasma generated from nitrous oxide or oxygen.

In addition, a plasma or thermal anneal after deposition of a thin film may be done for reasons other than the improvement of barrier properties alone. For example, after depositing a thin film of aluminum, a second plasma annealing may be performed using fluorine (F₂) or nitrogen trifluoride (NF₃) in order to prevent grain grown in the aluminum film.

While the plasma or thermal annealing process or processes may be performed within the same process chamber in which the films are sputter deposited, it is also possible to perform the thermal or plasma annealing in a different chamber, provided that the wafer on which the thin film is deposited remains under vacuum when being transported between chambers.

For example, Figure 3 shows a top view of semiconductor processing equipment 1 in which sputter deposition of a thin film can be performed in one chamber before transportation to another chamber for a plasma and/or thermal anneal. Semiconductor processing equipment 1 allows for transportation of wafers between chambers while the wafers remain under vacuum.

Wafers enter the semiconductor processing equipment 1 through cassette load locks. For example, in a load lock chamber 8, a wafer cassette 11 holds wafers. In another load lock chamber 9, a wafer cassette 15 holds other wafers. The load lock chamber 8 and the load lock chamber 9 may be separately and individually pumped down.

Semiconductor processing equipment 1 includes, for example, a de-gas/water orienter chamber 5, a pre-clean chamber 13, a physical vapor deposition (PVD) chamber 16, a PVD chamber 17, a PVD chamber 18, a PVD chamber 19, a cool down chamber 14, a plasma anneal chamber 20 and a cool down chamber 6. A transfer chamber 21 may be used to temporarily store wafers on robotic equipment 7 when wafers are being moved to or from various of the chambers. Similarly, a transfer chamber 22 may be used to temporarily store wafers on robotic equipment 23 when wafers are being moved to or from various of the chambers. All the chambers, except load lock chamber 8 and load lock chamber 9, remain under vacuum during processing of the wafers. For example, a nitrous oxide anneal may be performed in chamber 13 for example.

A titanium nitride film was deposited onto a silicon substrate and a thin aluminum film deposited thereover. The sandwich was thermally annealed by heating for 90 minutes at 450°C.

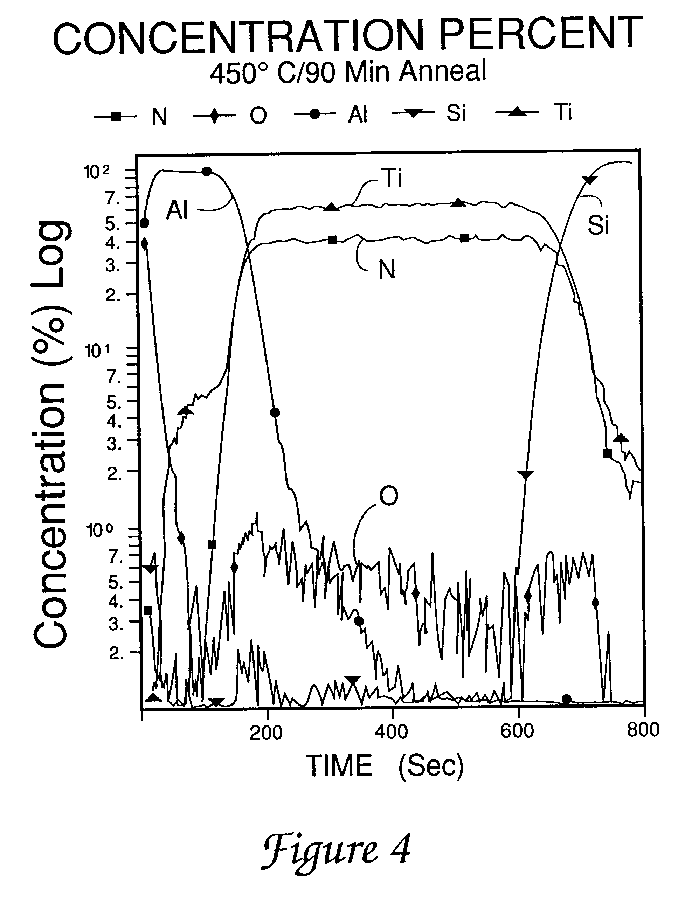

Figure 4 is an SNMS graph of the resultant thin films. As can be seen by referring to Figure 4, titanium and nitrogen have migrated into both the underlying silicon and the overlying aluminum layers. The aluminum has also migrated into the titanium nitride film.

A plasma or thermal anneal in accordance with the prior art process was performed by exposing a titanium nitride film on silicon to air for one-half hour. Aluminum was deposited thereover and then the sandwich was thermally annealed.

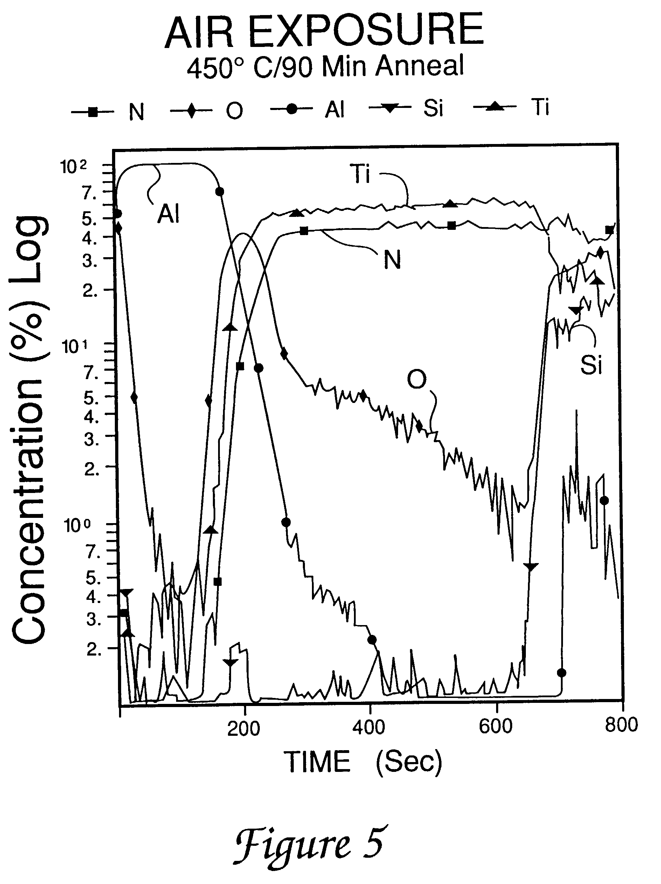

Figure 5 is an SNMS graph of the resultant thin films. As can be seen in Figure 5, titanium and nitrogen have migrated both into the silicon substrate and into the overlying aluminum layer. Moreover, there is an oxide layer at the interface between the titanium nitride and the aluminum film and the oxide also has migrated into the titanium nitride film in variable concentration. It will be understood that the oxygen content and the depth of the oxide interfacial layer is very difficult to reproduce and control using this process.

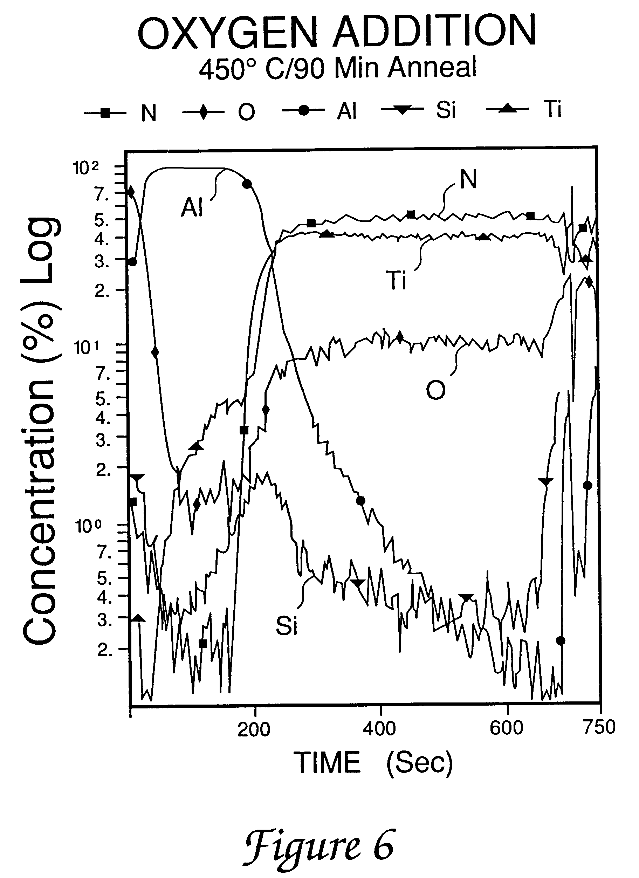

In accordance with the process of the invention, a deposited titanium nitride film on silicon was plasma annealed in oxygen, without removing the titanium nitride film from the titanium nitride deposition chamber, prior to depositing an aluminum film thereover. As can be seen by reference to Figure 6, the SNMS graph shows that no separate oxide layer is present at the interface of the titanium nitride and aluminum films. Although there is still some migration of titanium into the aluminum film and into the silicon substrate, this anneal in oxygen results in a repeatable, controlled oxidation of the titanium nitride film.

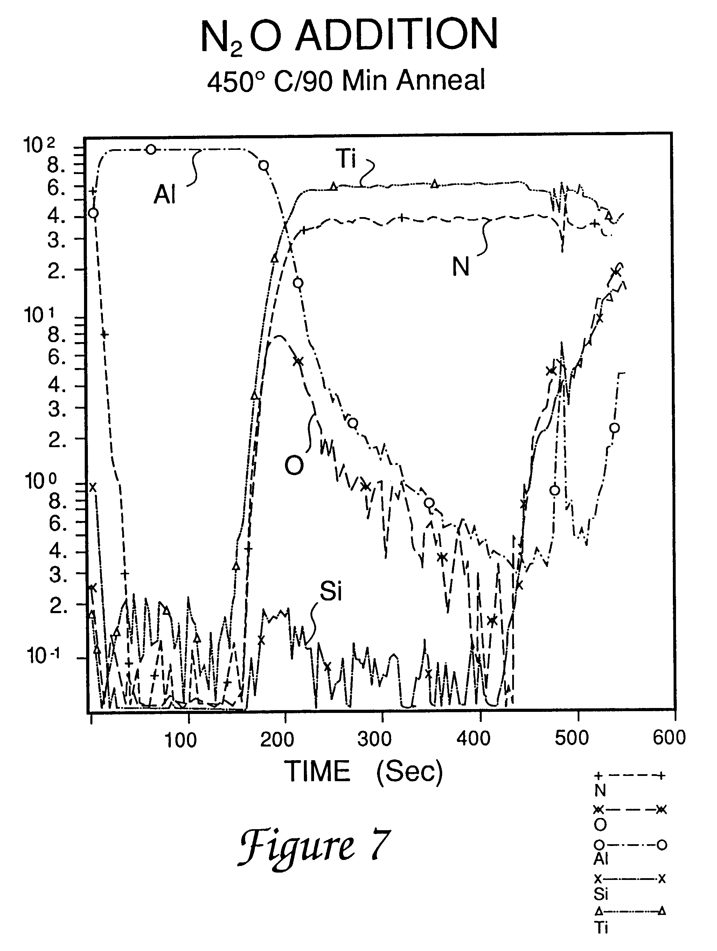

In another embodiment of the present process, a titanium nitride film was plasma annealed for one minute in nitrous oxide prior to depositing an aluminum film thereover. As can be seen by reference to Figure 7, the SNMS graph shows that no separate oxide layer is present at the interface of the titanium nitride-aluminum films, and there is almost no migration of titanium into the aluminum film.

Another measure of the diffusion of titanium into an aluminum conductive film is to measure the change in sheet resistance ratio with time of the titanium nitride/aluminum sandwich structure of Figure 7 that has been annealed in nitrogen at 450°C. The sheet resistance ratio will be at a minimum for the structure having the least amount of interdiffusion.

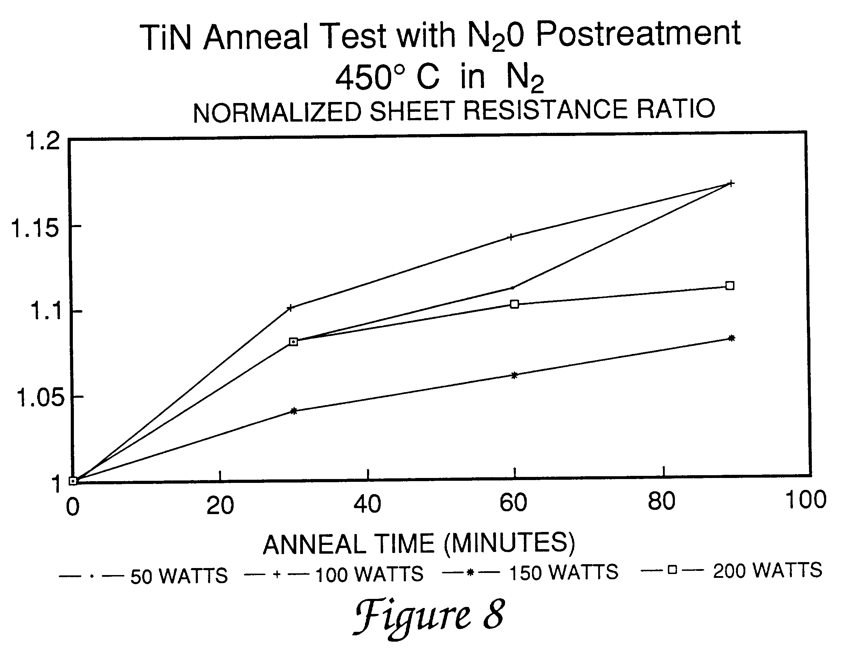

Figure 8 illustrates the variation of sheet resistance with time at varying sputter etch power. The amount of titanium diffusion in the aluminum film can be controlled by varying the applied power. In this example, the sheet resistance ratio of the sandwich of Figure 7 is minimized at a power of 150 watts.

The invention has been described above in terms of particular embodiments, but it will be apparent to those skilled in the art that various substitutions of material, gases and substrates may be made in accordance with the appended claims.

## Claims

1. A method of enhancing the barrier properties of a thin film on a semiconductor substrate comprising:
a) sputter depositing a thin film of a contact barrier material comprising a compound of a metal on a substrate in a vacuum environment and
b) without removing the substrate from the vacuum environment, annealing the vacuum deposited thin film.

2. A method according to claim 1 wherein the annealing is performed in a plasma.

3. A method according to claim 1 or 2, wherein the annealing is performed at an elevated temperature.

4. A method according to one of the preceding claims wherein said thin film is of titanium nitride, titanium tungsten or tantalum nitride.

5. A method according to claim 2, wherein said thin film is of titanium nitride and said plasma is of nitrous oxide or oxygen.

6. A method according to claim 2, wherein said thin film is of titanium tungsten and said plasma is of nitrogen or ammonia.

7. A method according to claim 2 wherein said thin film is of tantalum nitride and said plasma is of nitrous oxide or oxygen.

8. A method according to one of the preceding claims wherein after annealing said thin film, a film of aluminum is deposited thereover.

9. A method according to claim 8, wherein said aluminum film is annealed in a vacuum environment.

10. A method according to claim 9, wherein the aluminum film is annealed by a plasma of fluorine or nitrogen trifluoride.

11. A method according to one of the preceding claims, wherein both steps a) and b) are performed in the same vacuum chamber.

12. A method according to one of claims 1 to 10 wherein steps a) and b) are performed in separate vacuum chambers.

13. A method according to one of the preceding claims wherein said substrate is a wafer, preferably a silicon semiconductor wafer.

## Patentansprüche

1. Verfahren zur Verbesserung der Barriereeigenschaften eines dünnen Films auf einem Halbleitersubstrat, das folgendes umfaßt:
a) Zerstäubungsabscheidung eines dünnen Films eines Kontaktbarrierematerials mit einer Verbindung aus einem Metall auf einem Substrat in einer Vakuumumgebung und
b) ohne Entfernung des Substrats von der Vakuumumgebung, Tempern des vakuumabgeschiedenen dünnen Films.

2. Verfahren gemäß Anspruch 1, bei dem das Tempern in einem Plasma erfolgt.

3. Verfahren gemäß Anspruch 1 oder 2, bei dem das Tempern bei erhöhter Temperatur erfolgt.

4. Verfahren gemäß einem der vorhergehenden Ansprüche, bei dem der dünne Film aus Titaniumnitrid, Titaniumwolfram oder Tantalnitrid ist.

5. Verfahren gemäß Anspruch 2, bei dem der dünne Film aus Titaniumnitrid ist und das Plasma aus Distickstoffoxid oder Sauerstoff ist.

6. Verfahren gemäß Anspruch 2, bei dem der dünne Film aus Titaniumwolfram und das Plasma aus Stickstoff oder Ammoniak ist.

7. Verfahren gemäß Anspruch 2, bei dem der dünne Film aus Tantalnitrid ist und das Plasma aus Distickstoffoxid oder Sauerstoff ist.

8. Verfahren gemäß einem der vorhergehenden Ansprüche, bei dem nach dem Tempern des dünnen Films ein Aluminiumfilm darüber abgeschieden wird.

9. Verfahren gemäß Anspruch 8, bei dem der Aluminiumfilm in einer Vakuumumgebung getempert wird.

10. Verfahren gemäß Anspruch 9, bei dem der Aluminiumfilm durch ein Plasma aus Fluor oder Stickstofftrifluorid getempert wird.

11. Verfahren gemäß einem der vorhergehenden Ansprüche, bei dem sowohl Schritt a) als auch Schritt b) in derselben Vakuumkammer erfolgt.

12. Verfahren gemäß einem der Ansprüche 1 bis 10, bei dem die Schritte a) und b) in separaten Vakuumkammern erfolgen.

13. Verfahren gemäß einem der vorhergehenden Ansprüche, bei dem es sich bei dem Substrat um einen Wafer, vorzugsweise einen Siliciumhalbleiterwafer, handelt.

## Revendications

1. Procédé d'amélioration des propriétés de barrière d'un film mince sur un substrat de semi-conducteur comprenant :
a) le dépôt par pulvérisation d'un film mince d'un matériau formant barrière de contact comprenant un composé d'un métal sur un substrat dans un milieu sous vide et
b) sans enlever le substrat du milieu sous vide, le recuit du film mince déposé sous vide.

2. Procédé selon la revendication 1, dans lequel le recuit est mis en oeuvre dans un plasma.

3. Procédé selon la revendication 1 ou 2, dans lequel le recuit est mis en oeuvre à une température élevée. ,

4. Procédé selon l'une des revendications précédentes, dans lequel ledit film mince est un film de nitrure de titane, de titane tungstène ou de nitrure de tantale.

5. Procédé selon la revendication 2, dans lequel ledit film mince est un film de nitrure de titane et ledit plasma est un plasma d'oxyde nitreux ou d'oxygène.

6. Procédé selon la revendication 2, dans lequel ledit film mince est un film de titane tungstène, et ledit plasma est un plasma d'azote ou d'ammoniac.

7. Procédé selon la revendication 2, dans lequel ledit film mince est un film de nitrure de tantale et ledit plasma est un plasma d'oxyde nitreux ou d'oxygène.

8. Procédé selon l'une des revendications précédentes, dans lequel, après le recuit dudit film mince, un film d'aluminium est déposé sur ce dernier.

9. Procédé selon la revendication 8, dans lequel ledit film d'aluminium est recuit dans un milieu sous vide.

10. Procédé selon la revendication 9, dans lequel ledit film d'aluminium est recuit par un plasma de fluor ou de trifluorure d'azote.

11. Procédé selon l'une des revendications précédentes, dans lequel les deux étapes a) et b) sont mises en oeuvre dans la même chambre à vide.

12. Procédé selon l'une des revendications 1 à 10 dans lequel les étapes a) et b) sont mises en oeuvre dans des chambres à vide séparées.

13. Procédé selon l'une des revendications. précédentes, dans lequel ledit substrat est une plaquette, de préférence une plaquette de semi-conducteur en silicium.
